# EUROPÄISCHE PATENTSCHRIFT

(11) **EP 3 679 264 B1**
(45) Veröffentlichungstag und Bekanntmachung des Hinweises auf die Patenterteilung: **10.11.2021**
(21) Anmeldenummer: 18756395.2
(22) Anmeldetag: 09.08.2018
(51) Int. Cl.: F16D 59/02

(54) **FEDERKRAFTBREMSE**
SPRING BRAKE
FREIN À RESSORT

(30) Priorität: 07.09.2017 DE 202017105432 U
(43) Veröffentlichungstag der Anmeldung: 15.07.2020
(73) Patentinhaber: Kendrion INTORQ GmbH, 31855 Aerzen (DE)
(72) Erfinder: KÜTER, Winfried, 31860 Emmerthal (DE); HANF, Matthias, 32791 Lage (DE); SCHAFMEISTER, Ernst, 32694 Dörentrup (DE)
(74) Vertreter: Westphal, Mussgnug & Partner Patentanwälte mbB
(86) Internationale Anmeldenummer: PCT/EP2018/071672
(87) Internationale Veröffentlichungsnummer: WO 2019/048178

(56) Entgegenhaltungen:
- EP-A1- 2 006 563
- CN-Y- 200 943 658
- DE-A1- 2 532 513
- GB-A- 1 388 470
- US-A- 3 015 318
- US-A- 3 020 094

## Beschreibung

Die Erfindung betrifft eine Federkraftbremse nach dem Oberbegriff des Anspruchs 1.

Federkraftbremsen der in Rede stehenden Art zeichnen sich insbesondere dadurch aus, dass zur Erzeugung einer Bremswirkung ein Bremselement mittels einer Schraubenfeder mit einer Kraft beaufschlagt wird. Die durch die Schraubenfeder auf das Bremselement aufgebrachte Kraft wird durch das Bremselement in eine Bremswirkung umgesetzt. Regelmäßig geschieht dies dadurch, dass die auf das Bremselement aufgebrachte Kraft zu einer Bewegung des Bremselements führt. Durch diese Bewegung werden hierfür ausgebildete Funktionsflächen miteinander in Kontakt gebracht und gegeneinandergedrückt. Bei den Funktionsflächen handelt es sich insbesondere um zu diesem Zweck ausgebildete Reibbeläge. Die zwischen den Funktionsflächen erzeugten Reibkräfte stellen schlussendlich die eigentlichen Bremskräfte dar.

Der Vorteil von Federkraftbremsen ist es, dass die Bremskraft grundsätzlich auch beim Ausfall jeglicher Hilfsenergie auf das Bremselement aufgebracht werden kann. Auf diese Weise lassen sich derartige Bremsen beispielsweise so gestalten, dass sie bei einem Stromausfall schließen. Dies ist in vielen Anwendungsfällen gewünscht, um die Betriebssicherheit technischer Einrichtungen zu gewährleisten.

Die Schraubenfedern, die zur Aufbringung der Kraft auf das Bremselement dienen, befinden sich bei Federkraftbremsen der in Rede stehenden Art regelmäßig in Federaufnahmen. Die Federaufnahmen dienen dabei zur Führung der Schraubenfedern entlang ihrer Erstreckungsrichtung. Unter der Erstreckungsrichtung einer Schraubenfeder ist in diesem Zusammenhang jene Richtung zu verstehen, in der die Schraubenfeder bei bestimmungsgemäßer Verwendung ihre Federkraft entfaltet. Eine Hauptaufgabe der Federaufnahme ist es, die Bewegung der Feder, die bei der Betätigung der Bremse entsteht, entlang der Erstreckungsrichtung der Schraubenfeder zu führen. Im Dokument EP 2 006 563 A1 ist ein zu dem Stand der Technik gehörendes Beispiel offenbart.

Es hat sich im Betrieb derartiger Federkraftbremsen gezeigt, dass die Lebensdauer der Schraubenfedern häufig dadurch begrenzt wird, dass es im Bereich des Endes der Schraubenfeder, das dem Bremselement zugewandt ist, zum Materialversagen kommt. Es versteht sich, dass ein derartiges Materialversagen gerade bei einer Federkraftbremse höchst problematisch ist. Schließlich dient die Federkraftbremse oftmals gerade dazu, ein ausfallsicheres Bremssystem bereitzustellen. Ein zuverlässiges Schließen - beispielsweise wie obenstehend beschrieben beim Ausfall einer Hilfsenergie - ist im Fall eines solchen Materialversagens jedoch nicht mehr gewährleistet.

Der Erfindung liegt die Aufgabe zugrunde, eine Federkraftbremse aufzuzeigen, die eine höhere Lebensdauer der Schraubenfedern gewährleistet.

Die Aufgabe wird gelöst durch eine Federkraftbremse mit den Merkmalen des Anspruchs 1. Die Merkmale der abhängigen Ansprüche betreffen vorteilhafte Ausführungsformen.

Erfindungsgemäß wird die Aufgabe dadurch gelöst, dass die Federaufnahme einen sich entlang der Schraubenfeder erstreckenden Führungsbereich und einen sich entlang der Schraubenfeder erstreckenden weiteren Bereich aufweist, wobei der weitere Bereich zwischen dem Führungsbereich und dem Bremselement angeordnet ist und einen größeren Querschnitt aufweist als der Führungsbereich.

Es hat sich gezeigt, dass der Verschleiß der Schraubenfedern daher rührt, dass Bewegungen des Bremselements in einer zur Erstreckungsrichtung der Schraubenfeder senkrechten Richtung zu einer verstärkten Verformung der Schraubenfeder im Bereich von deren dem Bremselement zugewandten Ende führen. Die Bewegungen des Bremselements entstehen aufgrund des Spiels, welches die Lagerung bzw. Führung des Bremselements typischerweise aufweist, in Verbindung mit den Reibkräften, die im Bremsbetrieb auf das Bremselement wirkende und typischerweise senkrecht zur Erstreckungsrichtung der Schraubenfeder stehen. Daher bewegt sich das Bremselement nicht nur - entsprechend seiner bestimmungsgemäßen Funktion - entlang der Erstreckungsrichtung der Schraubenfeder, es kommt vielmehr zusätzlich zu einer Bewegung, deren Richtung von den beim Betätigen der Bremse erzeugten Reibkräften abhängt. Nach dem Stand der Technik wirken sich die Bewegungen des Bremselements und die damit einhergehende Verformung der Schraubenfeder lediglich auf einen sehr kurzen Bereich der Schraubenfeder an deren dem Bremselement zugewandten Ende aus. Dies ist regelmäßig der Bereich der Schraubenfeder, der aus der Federaufnahme hervortritt. Regelmäßig handelt es sich hierbei um lediglich etwa eine einzige Windung der Schraubenfeder. Der gesamte Rest der Schraubenfeder wird durch die Federaufnahme abgestützt, sodass er von der Verformung durch die senkrecht zur Erstreckungsrichtung der Schraubenfeder gerichteten Bewegungen des Bremselement nicht betroffen ist.

Die erfindungsgemäße Lösung sieht nun vor, zwischen einem Führungsbereich der Federaufnahme und dem Bremselement einen weiteren Bereich der Federaufnahme vorzusehen, dessen Querschnitt größer ist als der Querschnitt des Führungsbereichs. In diesem Bereich kann sich die Feder in zu ihrer Erstreckungsrichtung senkrechter Richtung stärker bewegen, als es bei einer konventionellen Federaufnahme, deren Führungsbereich sich über deren gesamte Länge erstreckt, der Fall ist. Die senkrecht zur Erstreckungsrichtung orientierten Bewegungen des Bremselements führen so nicht lediglich zu einer Verformung eines minimalen Bereichs der Feder, die Feder kann sich vielmehr über einen größeren Teil ihrer Länge in Folge der Bewegungen des Bremselements verformen. Hierdurch verteilt sich die Materialbeanspruchung durch die Verformung über einen größeren Bereich der Schraubenfeder. Insgesamt reduziert sich auf diese Weise die Materialbelastung erheblich, was zu einer wesentlich erhöhten Lebensdauer der Schraubenfeder führt.

In diesem Zusammenhang ist es vorteilhaft, wenn sich der Führungsbereich der Federaufnahme entlang der Schraubenfeder über wenigstens 20 %, insbesondere wenigstens 50 %, und/oder höchstens 95 %, insbesondere höchstens 70 %, der Erstreckung der Federaufnahme entlang der Schraubenfeder erstreckt. Es hat sich gezeigt, dass diese Abmessungen des Führungsbereichs geeignet sind, zum einen eine zuverlässige Führung der Schraubenfeder zu gewährleisten, zum anderen eine hinreichend lange Erstreckung des weiteren Bereichs zu ermöglichen, um den erfindungsgemäßen Effekt zu erzielen.

Bevorzugt erstreckt sich der weitere Bereich entlang der Schraubenfeder über wenigstens 5 %, insbesondere wenigstens 30 %, und/oder höchstens 80 %, insbesondere höchstens 50 %, der Erstreckung der Federaufnahme entlang der Schraubenfeder. Es hat sich gezeigt, dass eine Erstreckung des weiteren Bereichs im Rahmen der vorgenannten Parameter zum einen den erfindungsgemäßen Effekt ermöglicht und es zum anderen erlaubt, einen hinreichend langen Führungsbereich vorzusehen, um eine sichere Führung der Schraubenfeder zu gewährleisten.

Bevorzugt ist die Federkraftbremse derart gestaltet, dass die Schraubenfeder beim Betrieb der Federkraftbremse nicht in Kontakt mit dem weiteren Bereich gelangt. Diese Gestaltung betrifft insbesondere den Querschnitt des weiteren Bereichs, der entsprechend gewählt ist. Wenn die Schraubenfeder beim Betrieb der Federkraftbremse nicht in Kontakt mit dem weiteren Bereich der Federaufnahme gelangt, werden lokale Deformationen einzelner Bereiche der Schraubenfeder, die zu einem vorzeitigen Materialversagen führen können, vermieden.

Bevorzugt ist die Federkraftbremse derart gestaltet, dass die Schraubenfeder beim Betrieb der Federkraftbremse keine plastische Verformung erfährt. Auch dies betrifft insbesondere die Gestaltung des Querschnitts des weiteren Bereichs. Es hat sich gezeigt, dass plastische Verformungen, die aus der Bewegung des Bremselement in zur Erstreckungsrichtung der Schraubenfeder senkrechter Richtung resultieren, in besonderem Maße für den frühzeitigen Verschleiß und ein mögliches Materialversagen der Schraubenfeder verantwortlich sind.

Bei der Federaufnahme kann es sich um eine Bohrung handeln. Diese kann beispielsweise im Magnetgehäuse einer elektromagnetisch betätigbaren Federkraftbremse vorgesehen sein. Die Ausführung der Federaufnahme als Bohrung stellt eine kostengünstige Möglichkeit dar, die Federaufnahme zu realisieren. Es sind jedoch auch andere Gestaltungen der Federaufnahme möglich.

Die Federaufnahme kann einen zwischen dem Führungsbereich und dem weiteren Bereich abgestuften Querschnitt aufweisen. Eine derartige abgestufte Ausgestaltung des Querschnitts hat den Vorteil, dass sie sich vergleichsweise einfach herstellen lässt. Beispielsweise kann die Federaufnahme als Stufenbohrungen ausgeführt sein.

Alternativ ist es möglich, den weiteren Bereich so zu gestalten, dass er sich zum Führungsbereich hin verjüngt. In diesem Zusammenhang kann der weitere Bereich bevorzugt konisch gestaltet sein. Eine derartige Gestaltung des weiteren Bereichs hat den Vorteil, dass der Bewegungsspielraum für die Schraubenfeder gerade dort am größten ist, wo sich die Fehler aufgrund der Bewegung des Bremselement am stärksten bewegt, nämlich im Bereich ihres dem Bremselement zugewandten Endes.

Federaufnahme, Führungsbereich und/oder weiterer Bereich können einen kreisrunden Querschnitt aufweisen. Im Fall des Führungsbereichs ist dies insbesondere deswegen vorteilhaft, da der Querschnitt einer typischen Schraubenfeder ebenfalls kreisrund ist. Um eine optimale Führung der Schraubenfeder zu gewährleisten, weist der Führungsbereich bevorzugt einen geringfügig größeren Querschnitt auf als die Schraubenfeder. Dies ist insbesondere deswegen notwendig, da die Schraubenfeder, wenn sie gestaucht wird, ihren Querschnitt ebenfalls minimal vergrößert. So kann bei einer kreisrunden Gestaltung des Querschnitts der Durchmesser des Führungsbereichs beispielsweise ca. 0,5 mm größer gestaltet sein als der Durchmesser des Querschnitts der Schraubenfeder im unbelasteten Zustand. Wenn die Federaufnahme beispielsweise als Stufenbohrung gestaltet ist, so hat es sich gezeigt, dass bereits ein um 1 mm größerer Durchmesser des weiteren Bereichs verglichen mit dem Durchmesser des Führungsbereichs eine signifikante Steigerung der Lebensdauer der Schraubenfeder bewirkt.

Der weitere Bereich kann jedoch auch einen von einer kreisrunden Form abweichenden Querschnitt aufweisen. Der Querschnitt ist dabei bevorzugt so gestaltet, dass er die Bewegungsrichtung des Bremselements berücksichtigt, die sich durch die Reibkräfte ergibt, welche im Bremsbetrieb auf das Bremselement wirken und typischerweise senkrecht zur Erstreckungsrichtung der Schraubenfeder gerichtet sind. So ist, beispielsweise bei einer Gestaltung der Federkraftbremse als Scheibenbremse, eine Aufweitung des Querschnitts des weiteren Bereichs gegenüber dem Querschnitt des Führungsbereichs in Umfangsrichtung der Federkraftbremse und/oder eines rotierenden Bremselements, insbesondere einer Bremsscheibe, besonders vorteilhaft.

Bevorzugt kann es sich um eine elektromagnetisch betätigbare Federkraftbremse handeln. Elektromagnetisch betätigbare Federkraftbremsen werden typischerweise mittels elektrischer Hilfsenergie gelüftet und schließen aufgrund der Federkraftbremse derartigen Federkraftbremsen lassen sich in einfacher Weise mit elektrischen Mitteln ansteuern und bieten eine hohe Betriebssicherheit, da sie beim Wegfall der elektrischen Hilfsenergie automatisch schließen.

Bei dem Bremselement kann es sich um eine Ankerscheibe handeln. Unter einer Ankerscheibe versteht man ein scheibenförmiges Bremselement, welches beispielsweise mit einem Reibbelag ausgestattet sein kann. Das Bremselement ist regelmäßig so angeordnet, dass es eine Welle umgibt. Auf dieser Welle ist bevorzugt eine rotierendes Bremselement, beispielweise ein Bremsrotor und/oder eine Bremsscheibe angeordnet. Besonders bevorzugt ist das rotierende Bremselement in axialer Richtung der Welle auf der Welle verschieblich und/oder drehfest mit der Welle verbunden. Zum Erzeugen der Bremswirkung wird das Bremselement gegen das rotierende Bremselement gepresst. Bevorzugt - nämlich insbesondere im Fall eines axial beweglichen Bremselements - wird das Bremselement hierdurch gegen ein Bremsgegenelement gedrückt, wobei zwischen dem rotierenden Bremselement und dem Bremsgegenelement ebenfalls Reibkräfte entstehen. Bremselement und/oder rotierendes Bremselement und/oder Bremsgegenelement sind hierfür bevorzugt mit geeigneten Reibbelägen ausgestattet.

Es versteht sich, dass eine erfindungsgemäße Federkraftbremse eine Mehrzahl Schraubenfedern in einer entsprechenden Mehrzahl Federaufnahmen aufweisen kann, die ein Bremselement der Federkraftbremse mit einer Kraft beaufschlagen. In diesem Fall treffen die erfindungsgemäßen und/oder vorteilhaften Merkmale bevorzugt auf die Gestaltung sämtlicher Federaufnahmen der Federkraftbremse zu.

Die Erfindung wird im Folgenden anhand der Figuren 1 bis 6 schematisch näher erläutert.
Fig. 1 zeigt eine schematische Darstellung eines Schnittes durch eine Federaufnahme einer Federkraftbremse nach dem Stand der Technik.
Fig. 2 zeigt eine schematische Darstellung eines Schnittes durch die Federaufnahme einer beispielhaften erfindungsgemäßen Federkraftbremse, wobei die Federaufnahme als Stufenbohrung ausgeführt ist.
Fig. 3 zeigt eine schematische Darstellung eines Schnittes durch eine Federaufnahme einer beispielhaften erfindungsgemäßen Federkraftbremse, wobei der weitere Bereich der Federaufnahme konisch gestaltet ist.
Fig. 4 zeigt eine Schnittdarstellung einer beispielhaften erfindungsgemäßen Federkraftbremse, wobei die Federaufnahme als Stufenbohrung ausgeführt ist.
Fig. 5 zeigt eine Schnittdarstellung einer beispielhaften erfindungsgemäßen Federkraftbremse, wobei der weitere Bereich konisch gestaltet ist.
Fig. 6 zeigt eine schematische Draufsicht auf die Federaufnahme einer beispielhaften erfindungsgemäßen Federkraftbremse, wobei der Querschnitt des weiteren Bereichs von einer kreisrunden Form abweicht.

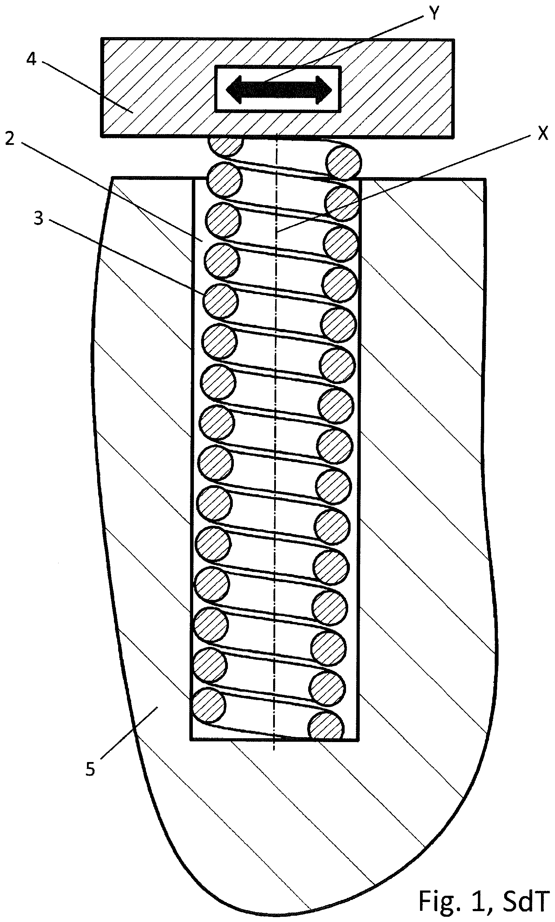

Bei einer Federkraftbremse 1 nach dem Stand der Technik weist die Federaufnahme 2 für die Schraubenfeder 3 typischerweise eine der Darstellung in Fig. 1 entsprechende Gestaltung auf. Die Schraubenfeder 3 erstreckt sich entlang ihrer Erstreckungsrichtung X. Die Erstreckungsrichtung X der Schraubenfeder 3 ist auch die Richtung, in der die Kraft wirkt, mit der die Schraubenfeder 3 das Bremselement 4 beaufschlagt. Die Federaufnahme 2 ist im gezeigten Beispiel als Bohrung in dem Gehäuse 5 der Federkraftbremse 1 ausgeführt. Aufgrund von Toleranzen und des daraus resultierenden Spiels bewegt sich das Bremselement 4 in einer rechtwinklig zur Erstreckungsrichtung X orientierten Bewegungsrichtung Y. Hierdurch wird der dem Bremselement 4 zugewandte Endbereich der Schraubenfeder 3 gegen die Wand der Federaufnahme 2 gedrückt. Hierdurch kommt es zu einer starken mechanischen Belastung des dem Bremselement 4 zugewandten Endbereich der Schraubenfeder 3. Dies führt in letzter Konsequenz zu einer begrenzten Lebensdauer der Schraubenfeder 3.

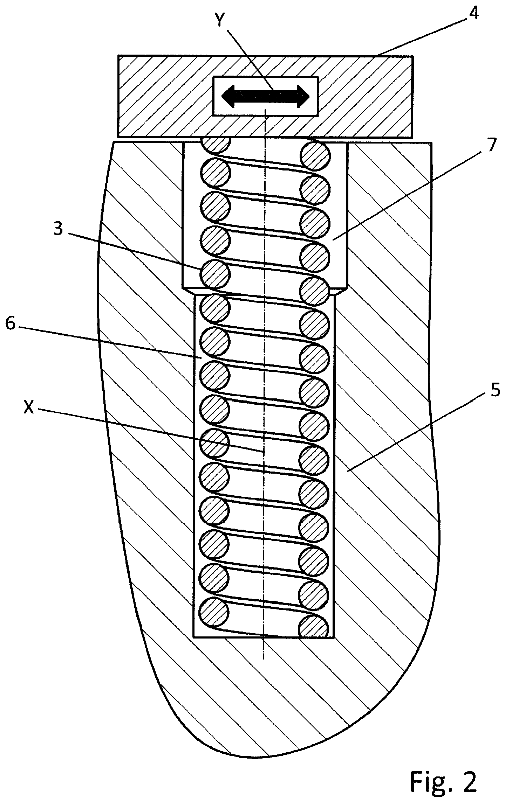

In Fig. 2 ist hingegen eine erfindungsgemäße Ausbildung einer Federaufnahme 2 dargestellt. Die Federaufnahme 2 ist im gezeigten Beispiel als Stufenbohrung ausgeführt. Die erfindungsgemäße Federaufnahme 2 weist einen Führungsbereich 6 und einen weiteren Bereich 7 auf. Der weitere Bereiche 7 weist einen größeren Querschnitt auf als der Führungsbereich 6. Auf diese Weise kann die Schraubenfeder 3 durch den Führungsbereich 6 eine ausreichende Führung entlang ihrer Erstreckungsrichtung X erfahren. Gleichzeitig kann sich das dem Bremselement 4 zugewandte Ende der Schraubenfeder 3 ausreichend frei bewegen, um eine erhöhte Belastung des unmittelbaren Endbereichs der Schraubenfeder 3, der dem Bremselement 4 zugewandt ist, zu vermeiden.

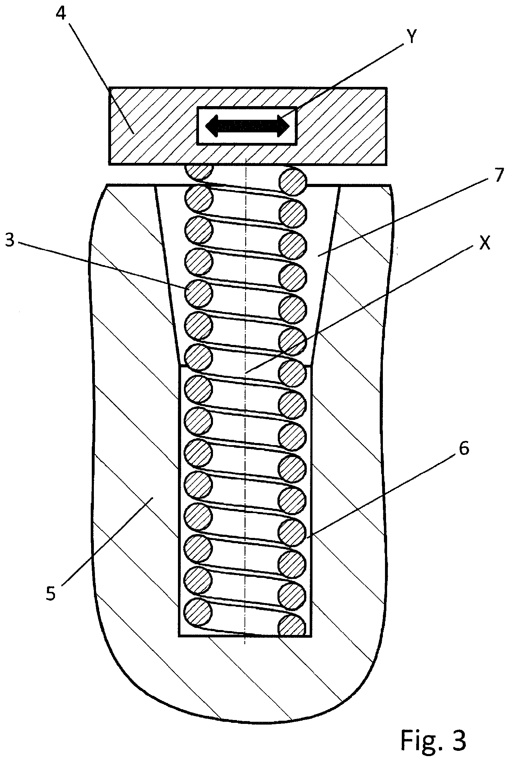

Eine Alternative Ausführungsform der vorliegenden Erfindung ist in Fig. 3 dargestellt. Der weitere Bereich 7 ist bei dieser Ausführungsform konisch gestaltet. Der erfindungsgemäße Effekt ist grundsätzlich der gleiche wie im Fall der in Fig. 2 dargestellten Ausführungsform. Die Schraubenfeder 3 hat im Bereich ihres dem Bremselement 4 zugewandten Endes einen größeren Bewegungsspielraum in der Bewegungsrichtung Y des Bremselements 4.

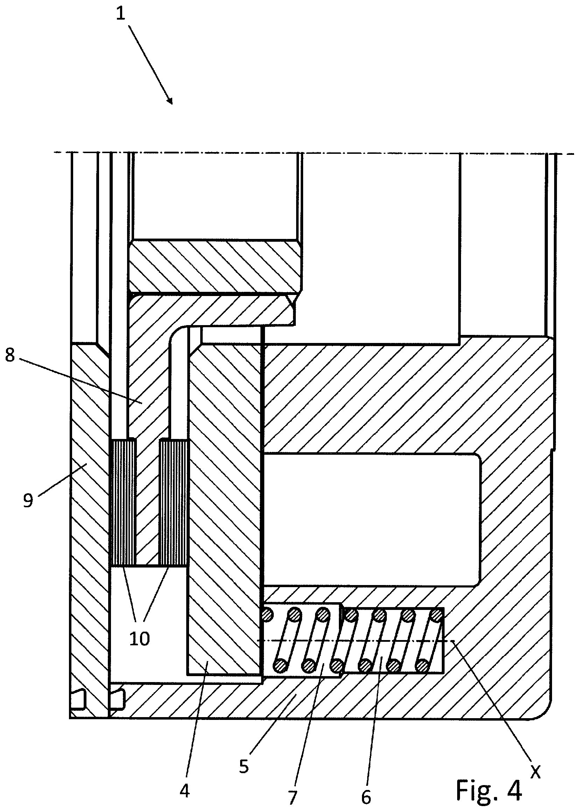

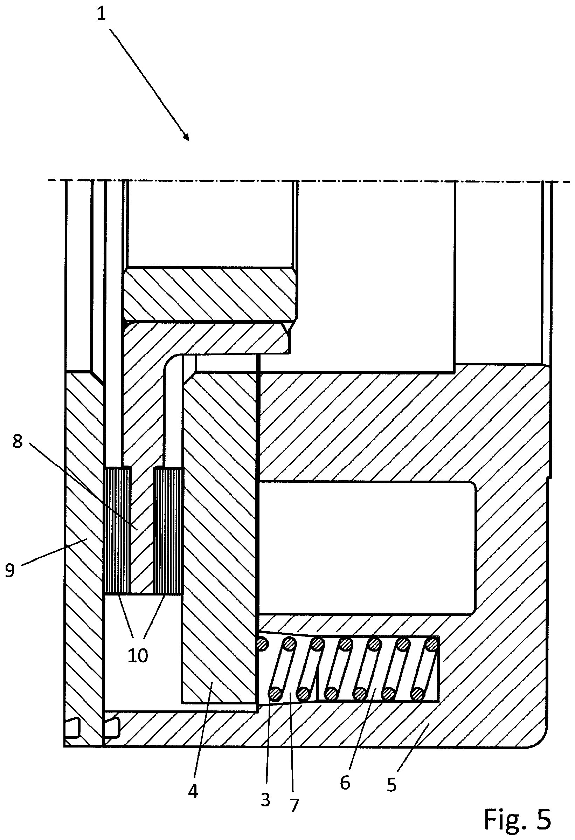

In den Figuren 4 und 5 sind Schnittdarstellungen beispielhafter Federkraftbremsen 1 gezeigt. Im Fall der in Fig. 4 dargestellten Federkraftbremse 1 entspricht die Gestaltung der Federaufnahme 2 als Stufenbohrung im Wesentlichen dem in Fig. 2 dargestellten Ausführungsbeispiel. Die in Fig. 5 dargestellte beispielhafte Federkraftbremse 1 weist entsprechend einen konisch gestalteten weiteren Bereich 7 auf, dessen Gestaltung im Wesentlichen der des weiteren Bereichs 7 aus dem in Fig. 3 gezeigten Ausführungsbeispiel entspricht. Das Bremselement 4 ist in den gezeigten Beispielen als Ankerscheibe ausgeführt. Beim Betätigen der Bremse bewegt sich das Bremselement 4 parallel zur Erstreckungsrichtung X der Schraubenfeder 3. In den gezeigten Beispielen wirkt das Bremselement 4 auf ein rotierendes Bremselement 8, im gezeigten Beispiel einen Bremsrotor. Dieser wiederum wird gegen ein Bremsgegenelement 9 gedrückt. Das Bremselement 4 und/oder das rotierende Bremselement 8 und/oder das Bremsgegenelement 9 sind in vorteilhafter Weise mit Reibbelägen 10 ausgestattet. Dass rotierende Bremselement 8 ist relativ zur Federkraftbremse 1 entlang der Erstreckungsrichtung X der Schraubenfedern 3 verschieblich gelagert.

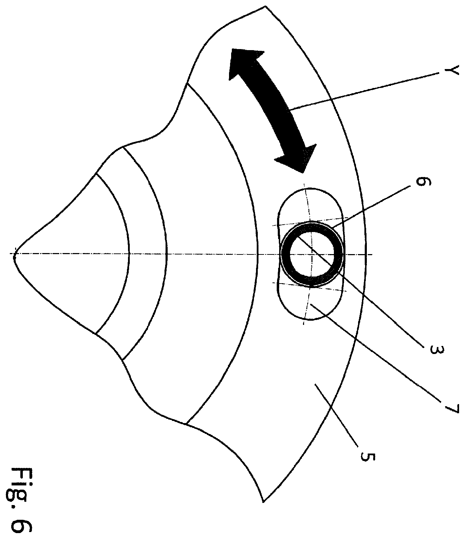

In Fig. 6 ist eine weitere Ausführungsform einer erfindungsgemäßen Federkraftbremse 1 dargestellt. Bei dieser Federkraftbremse 1 ist der weitere Bereich 7 gegenüber dem Führungsbereich 6 in seinem Querschnitt vergrößert, weist jedoch keinen kreisrunden Querschnitt auf. Der weitere Bereich 7 ist vielmehr nach Art eines Langlochs gestaltet. Dabei ist der Querschnitt des weiteren Bereichs 7 gegenüber dem Querschnitt des Führungsbereichs 6 insbesondere derart vergrößert, dass die Schraubenfeder 3 einen erweiterten Bewegungsbereich in Richtung der zur Erstreckungsrichtung X der Schraubenfeder 3 rechtwinkligen Bewegungsrichtung Y des Bremselements 4 hat. Die Bewegungsrichtung Y ist - wie auch im Fall der in Fig. 4 und 5 gezeigten Beispiele - eine gekrümmte Richtung, da sie der Umfangsrichtung der Federkraftbremse 1, in der die für die Bremswirkung verantwortlichen Reibkräfte wirken, entspricht.

### Bezugszeichen:

- 1: Federkraftbremse
- 2: Federaufnahme
- 3: Schraubenfeder
- 4: Bremselement
- 5: Gehäuse
- 6: Führungsbereich
- 7: weiterer Bereich
- 8: rotierendes Bremselement
- 9: Bremsgegenelement
- 10: Reibbeläge

- X: Erstreckungsrichtung der Schraubenfeder
- Y: Bewegungsrichtung

## Patentansprüche

1. Federkraftbremse (1), mit einer Mehrzahl Schraubenfedern (3) zum Aufbringen einer Kraft auf ein Bremselement (4) zur Erzeugung einer Bremswirkung und einer Mehrzahl Federaufnahmen (2) zur Aufnahme von jeweils einer der Mehrzahl Schraubenfedern (3), wobei das Bremselement (4) eine Welle umgibt, auf der ein rotierendes Bremselement (8) angeordnet und in axialer Richtung verschieblich und drehfest mit der Welle verbunden ist, wobei zum Erzeugen der Bremswirkung das Bremselement (4) gegen das rotierende Bremselement gepresst wird, wobei die Federaufnahmen (2) jeweils einen sich entlang der jeweiligen Schraubenfeder (3) erstreckenden Führungsbereich (6) und einen sich entlang der jeweiligen Schraubenfeder erstreckenden weiteren Bereich (7) aufweisen,
**dadurch gekennzeichnet, dass** der weitere Bereich (7) zwischen dem Führungsbereich (6) und dem Bremselement (4) angeordnet ist und einen größeren Querschnitt aufweist als der Führungsbereich (6) .

2. Federkraftbremse (1) nach Anspruch 1,
**dadurch gekennzeichnet, dass** der Führungsbereich (6) sich entlang der Schraubenfeder (3) über wenigstens 20% bevorzugt wenigstens 50%; und/oder höchstens 95%, bevorzugt höchstens 70%, der Erstreckung der Federaufnahme (2) entlang der Schraubenfeder (3) erstreckt.

3. Federkraftbremse (1) nach Anspruch 1 oder 2,
**dadurch gekennzeichnet, dass** der weitere Bereich (7) sich entlang der Schraubenfeder (3) über wenigstens 5%, bevorzugt wenigstens 30%, und/oder höchstens 80%, bevorzugt höchstens 50%, der Erstreckung der Federaufnahme entlang der Schraubenfeder (3) erstreckt.

4. Federkraftbremse (1) nach einem der vorigen Ansprüche, **dadurch gekennzeichnet, dass** die Federkraftbremse (1) derart gestaltet, insbesondere der Querschnitt des weiteren Bereichs (7) so gewählt ist, dass die Schraubenfeder (3) beim Betrieb der Federkraftbremse (1) nicht in Kontakt mit dem weiteren Bereich (7) gelangt.

5. Federkraftbremse(1) nach einem der vorigen Ansprüche, **dadurch gekennzeichnet, dass** die Federkraftbremse (1) derart gestaltet, insbesondere der Querschnitt des weiteren Bereichs (7) so gewählt ist, dass die Schraubenfeder (3) beim Betrieb der federkraftbremse (1) keine plastische Verformung erfährt.

6. Federkraftbremse (1) nach einem der vorigen Ansprüche, **dadurch gekennzeichnet, dass** die Federaufnahmen (2) Bohrungen sind.

7. Federkraftbremse (1) nach einem der vorigen Ansprüche, **dadurch gekennzeichnet, dass** das die Federaufnahmen jeweils (2) einen zwischen Führungsbereich (6) und weiterem Bereich (7) abgestuften Querschnitt aufweisen, insbesondere Stufenbohrungen sind.

8. Federkraftbremse (1) nach einem der vorigen Ansprüche, **dadurch gekennzeichnet, dass** der weitere Bereich (7) sich zum Führungsbereich (6) hin verjüngt, insbesondere konisch gestaltet ist.

9. Federkraftbremse(1) nach einem der vorigen Ansprüche, **dadurch gekennzeichnet, dass** die Federaufnahmen (2) jeweils einen kreisrunden Querschnitt aufweisen.

10. Federkraftbremse (1) nach einem der vorigen Ansprüche, **dadurch gekennzeichnet, dass** der Führungsbereich (6) einen kreisrunden Querschnitt aufweist.

11. Federkraftbremse (1) nach einem der vorigen Ansprüche, **dadurch gekennzeichnet, dass** der weitere Bereich (7) einen kreisrunden Querschnitt aufweist.

12. Federkraftbremse nach einem der Ansprüche 1 bis 11,
**dadurch gekennzeichnet, dass** der weitere Bereich (7) einen von einer kreisrunden Form abweichenden Querschnitt aufweist, insbesondere wobei sich in Umfangsrichtung der Federkraftbremse (1) eine Aufweitung des Querschnitts des weiteren Bereichs (7) gegenüber dem Querschnitt des Führungsbereichs (6) ergibt.

13. Federkraftbremse (1) nach einem der vorigen Ansprüche, **dadurch gekennzeichnet, dass** es sich um eine elektromagnetisch betätigbare, insbesondere elektromagnetisch lüftende, Federkraftbremse (1) handelt.

14. Federkraftbremse (1) nach einem der vorigen Ansprüche, **dadurch gekennzeichnet, dass** das Bremslement (4) eine Ankerscheibe ist.

15. Federkraftbremse (1) nach einem der vorigen Ansprüche, **dadurch gekennzeichnet, dass** die Federkraftbremse (1) ein rotierendes Bremselement (8), insbesondere einen Bremsrotor und/oder eine Bremsscheibe, aufweist.

## Claims

1. Spring loaded brake (1) with numerous coil springs (3) for applying a force onto a braking element (4) in order to produce a braking effect, and with numerous spring seats (2) for retaining each one of the numerous coil springs (3), wherein the braking element (4) encompasses a shaft on which a rotating braking element (8) is arranged and to which it is moveably in an axial direction and non-rotatably attached, wherein, in order to generate the braking effect, the braking element (4) is pressed against the rotating braking element (8), wherein each of the spring seats (2) comprise a guide region (6) extending along the respective coil spring (3), and a further region (7) extending along the respective coil spring (3), **characterized in that** the further region (7) is arranged between the guide region (6) and the braking element (4) and comprises a larger cross-section than the guide region (6).

2. Spring loaded bake (1) in accordance with claim 1, **characterized in that** the guide region (6) extends along the coil spring (3) over at least 20%, preferably at least 50%; and/or at most 95%, preferably at most 70%, of the extent to which the spring seat (2) extends along the coil spring (3).

3. Spring loaded brake (1) in accordance with claim 1 or 2, **characterized in that** the further region (7) extends along the coil spring (3) over at least 5%, preferably at least 30%, and/or at most 80%, preferably at most 50%, of the extent to which the spring seat (2) extends along the coil spring (3).

4. Spring loaded brake (1) in accordance with any of the preceding claims, **characterized in that** the spring loaded brake (1) is implemented, in particular the cross-section of the further region (7) is selected, such that the coil spring (3) does not enter into contact with the further region (7) when the spring loaded brake (1) is in operation.

5. Spring loaded brake (1) in accordance with any of the preceding claims, **characterized in that** the spring loaded brake (1) is implemented, in particular the cross-section of the further region is selected, such that the coil spring (3) undergoes no plastic deformation when the spring loaded brake (1) is in operation.

6. Spring loaded brake (1) in accordance with any of the preceding claims, **characterized in that** the spring seats (2) are bore holes.

7. Spring loaded brake (1) in accordance with any of the preceding claims, **characterized in that** each of the spring seats (2) comprise an intermediate guide region (6) and a further region (7) having a stepped cross-section, in particular stepped bore holes.

8. Spring loaded brake (1) in accordance with any of the preceding claims, **characterized in that** the further region (7) tapers towards the guide region (6) and, in particular, is implemented conically.

9. Spring loaded brake (1) in accordance with any of the preceding claims, **characterized in that** each of the spring seats (2) comprise a circular cross-section.

10. Spring loaded brake (1) in accordance with any of the preceding claims, **characterized in that** the guide region (6) comprises a circular cross-section.

11. Spring loaded brake (1) in accordance with any of the preceding claims, **characterized in that** the further region (7) comprises a circular cross-section.

12. Spring loaded brake (1) in accordance with any of the claims 1 to 11, **characterized in that** the further region (7) comprises a cross-section that diverges from a circular shape wherein, in particular, in the circumferential direction of the spring loaded brake (1), a widening of the cross-section of the further region (7) relative to the cross-section of the guide region (6) occurs.

13. Spring loaded brake (1) in accordance with any of the preceding claims, **characterized in that** the spring loaded brake (1) can be electromagnetically activated, in particular electromagnetically released.

14. Spring loaded brake (1) in accordance with any of the preceding claims, **characterized in that** the braking element (4) is an armature disc.

15. Spring loaded brake (1) in accordance with any of the preceding claims, **characterized in that** the spring loaded brake (1) comprises a rotating braking element (8), in particular a brake rotor and/or a brake disc.

## Revendications

1. Frein à ressort (1) comprenant une pluralité de ressorts hélicoïdaux (3) destinés à appliquer une force à un élément de freinage (4) de manière à produire un effet de freinage et une pluralité d'éléments de réception de ressort (2) destinés à recevoir chacun un ressort de la pluralité de ressorts hélicoïdaux (3), selon lequel l'élément de freinage (4) entoure un arbre sur lequel un élément de freinage (8) rotatif est disposé et relié à l'arbre de manière coulissante dans une direction axiale et non pivotante, selon lequel l'élément de freinage (4) est pressé contre l'élément de freinage rotatif afin de produire l'effet de freinage,
selon lequel les éléments de réception de ressort (2) comprennent chacun une zone de guidage (6) s'étendant le long des ressorts hélicoïdaux correspondants (3) et une autre zone (7) s'étendant le long des ressorts hélicoïdaux correspondants,
**caractérisé en ce que** l'autre zone (7) est disposée entre la zone de guidage (6) et l'élément de freinage (4) et a une plus grande section transversale que la zone de guidage (6).

2. Frein à ressort (1) selon la revendication 1, **caractérisé en ce que** la zone de guidage (6) s'étend le long du ressort hélicoïdal (3) sur au moins 20%, de préférence au moins 50%, et/ou au plus 95%, de préférence au plus 70% de l'extension de l'élément de réception de ressort (2) le long du ressort hélicoïdal (3).

3. Frein à ressort (1) selon l'une des revendications 1 ou 2, **caractérisé en ce que** l'autre zone (7) s'étend le long du ressort hélicoïdal (3) sur au moins 5%, de préférence au moins 30%, et/ou au plus 80%, de préférence au plus 50% de l'extension de l'élément de réception de ressort le long du ressort hélicoïdal (3).

4. Frein à ressort (1) selon l'une des revendications précédentes, **caractérisé en ce que** le frein à ressort (1) est formé de telle manière, en particulier la section transversale de l'autre zone (7) est choisie de telle manière que le ressort hélicoïdal (3) n'entre pas en contact avec l'autre zone (7) pendant le fonctionnement du frein à ressort (1).

5. Frein à ressort (1) selon l'une des revendications précédentes, **caractérisé en ce que** le frein à ressort (1) est formé de telle manière, en particulier la section transversale de l'autre zone (7) est choisie de telle manière que le ressort hélicoïdal (3) ne subit pas de déformation plastique pendant le fonctionnement du frein à ressort (1).

6. Frein à ressort (1) selon l'une des revendications précédentes, **caractérisé en ce que** les éléments de réception de ressort (2) sont des alésages.

7. Frein à ressort (1) selon l'une des revendications précédentes, **caractérisé en ce que** les éléments de réception de ressort (2) comprennent chacun une section transversale en gradins entre la zone de guidage (6) et l'autre zone (7), et en particulier sont des alésages étagés.

8. Frein à ressort (1) selon l'une des revendications précédentes, **caractérisé en ce que** l'autre zone (7) diminue en direction de la zone de guidage (6), et en particulier a une forme conique.

9. Frein à ressort (1) selon l'une des revendications précédentes, **caractérisé en ce que** les éléments de réception de ressort (2) comprennent chacun une section transversale circulaire.

10. Frein à ressort (1) selon l'une des revendications précédentes, **caractérisé en ce que** la zone de guidage (6) comprend une section transversale circulaire.

11. Frein à ressort (1) selon l'une des revendications précédentes, **caractérisé en ce que** l'autre zone (7) comprend une section transversale circulaire.

12. Frein à ressort (1) selon l'une des revendications 1 à 11, **caractérisé en ce que** l'autre zone (7) comprend une section transversale n'ayant pas une forme circulaire, et en particulier selon lequel on obtient, dans une direction périphérique du frein à ressort (1), un élargissement de la section transversale de l'autre zone (7) par rapport à la section transversale de la zone de guidage (6).

13. Frein à ressort (1) selon l'une des revendications précédentes, **caractérisé en ce qu'**il s'agit d'un frein à ressort (1) pouvant être actionné de manière électromagnétique, et en particulier d'un frein à ressort à ventilation électromagnétique.

14. Frein à ressort (1) selon l'une des revendications précédentes, **caractérisé en ce que** l'élément de frein (4) est un disque d'armature.

15. Frein à ressort (1) selon l'une des revendications précédentes, **caractérisé en ce que** le frein à ressort (1) comprend un élément de frein rotatif (8), en particulier un rotor de frein et/ou un disque de frein.
